# EUROPÄISCHE PATENTANMELDUNG

(11) **EP 1 653 512 A2**
(43) Veröffentlichungstag der Anmeldung: **03.05.2006**
(21) Anmeldenummer: 05018726.9
(22) Anmeldetag: 29.08.2005
(51) Int. Cl.: H01L 27/02

(54) **Schaltungsanordnung mit Schutz gegen elektrostatische Zerstörung**

(30) Priorität: 26.10.2004 DE 102004052093
(71) Anmelder: Micronas GmbH, 79108 Freiburg i. Br. (DE)
(72) Erfinder: Czech, Martin, 79117 Freiburg (DE); Albert, Michael, 77955 Ettenheim (DE)
(74) Vertreter: Patentanwälte Westphal, Mussgnug & Partner

(57) **Zusammenfassung**

Die Erfindung bezieht sich auf eine Schaltungsanordnung mit Schutz gegen elektrostatische Zerstörung mit zumindest zwei Abschnitten (A, B) aus einem ersten und einem zweiten Abschnitt (A, B), wobei jeder der Abschnitte (A, B) jeweils ein eigenes Betriebsspannungssystem mit einer Grundspannung (USS bzw. USS1) und einer Versorgungsspannung (UDD bzw. UDD1) aufweist und mit zumindest einer Verbindung (SC) zwischen einem Informationsanschlusspunkt (SA) des ersten Abschnitts (A) und zwischen einem Informationsanschlusspunkt (SB) des zweiten Abschnitts (B) zum Übertragen von Informationen zwischen dem ersten Abschnitt (A) und dem zweiten Abschnitt B, wobei die Verbindung (SC) eine Transistorschaltung mit zumindest einem ersten Transistor (X) des ersten Abschnitts (A), einem Widerstand (R1) und einem ersten Transistor (E) des zweiten Abschnitts (B) aufweist, wobei der erste Transistor (X) zwischen die Grundspannung (USS) des ersten Abschnitts (A) und den Widerstand (R1) und der erste Transistor (E) des zweiten Abschnitts (B) zwischen den Widerstand (R1) und die Versorgungsspannung (UDD1) des zweiten Abschnitts (B) geschaltet ist.

## Beschreibung

Die Erfindung bezieht sich auf eine Schaltungsanordnung mit den oberbegrifflichen Merkmalen des Patentanspruchs 1.

Schaltungsanordnungen und insbesondere integrierte Schaltungen werden immer komplizierter. Sie enthalten oftmals separate Teile bzw. Abschnitte, welche eine separate Spannungs-/Stromversorgung aufweisen. D.h., von zumindest zwei Abschnitten, welche einen ersten und einen zweiten Abschnitt der Schaltungsanordnung ausbilden, weist jeder der Abschnitte ein eigenes Betriebsspannungssystem mit Masse als einer Grundspannung und einer Versorgungsspannung auf. Zur Übertragung von Informationen sind die beiden Abschnitte über zumindest eine Verbindung miteinander verbunden. D.h., es besteht eine Verbindung zwischen einem Informationsanschlusspunkt des ersten Abschnitts und einem Informationsanschlusspunkt des zweiten Abschnitts zum Übertragen von Informationen zwischen dem ersten Abschnitt und dem zweiten Abschnitt.

Bei solchen Anordnungen ist nachteilhaft, dass im Fall elektrostatischer Entladungen Potentialdifferenzen zwischen den Abschnitten bzw. Teilen auftreten, welche über insbesondere die Verbindung zwischen den Informationsanschlusspunkten die Strukturen der Schaltungsanordnung zerstören. Problematisch ist dabei, dass die Strukturen der Schaltungsanordnung mit zunehmender Verkleinerung der Bauweise immer empfindlicher gegen elektrostatische Entladungen werden.

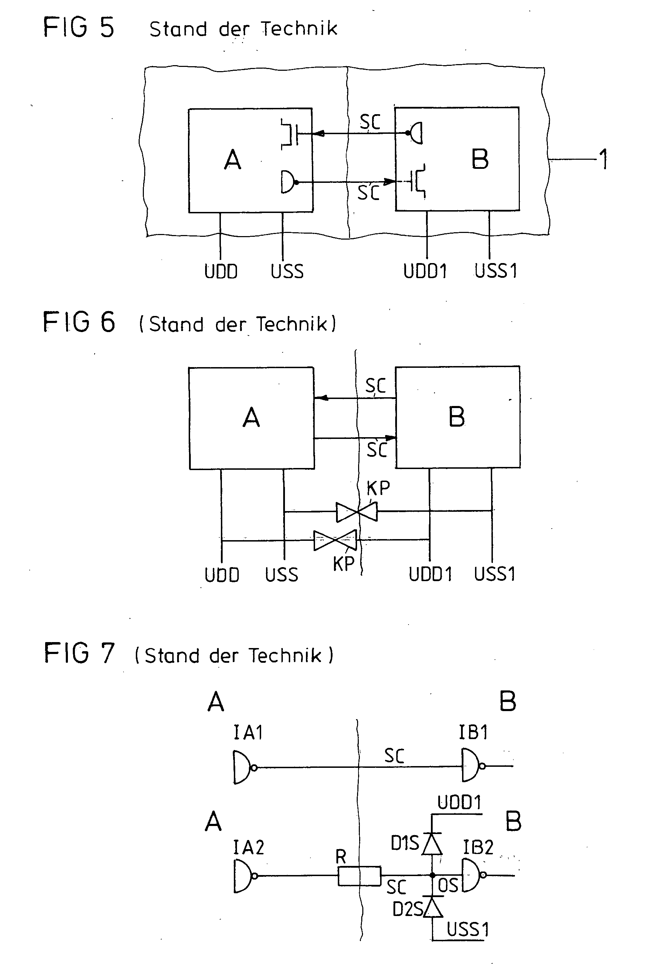

Fig. 5 zeigt beispielhaft einen Ausschnitt eines Kristalls 1 einer Schaltungsanordnung, wobei sich auf dem Kristall 1 der als integrierte Schaltung ausgebildeten Schaltungsanordnung zwei Abschnitte A, B befinden. Die beiden Abschnitte A, B sollen möglichst separat gehalten werden, um z.B. wechselseitige Störeinflüsse zu vermeiden. Trotzdem müssen Signale bzw. Informationen zwischen den Abschnitten A, B ausgetauscht werden. Die Signale werden an entsprechenden Informationsanschlusspunkten bereitgestellt und stammen bei einer Bauweise in CMOS-Technik (CMOS: Complementary Metal Oxide Semiconductor) von Invertern oder Inverter-ähnlichen Strukturen, z.B. einem NAND (NOT-AND-Anordnung) oder linearen Verstärkern. Die Signale werden typischerweise an den Gates bzw. Steueranschlüssen von MOS-Transistoren des jeweils anderen Abschnitts B, A angelegt. Wird nun das Spannungssystem aus einer Versorgungsspannung UDD und einer Masse bzw. Grundspannung USS des ersten Abschnitts A gegenüber dem Spannungssystem aus Versorgungsspannung UDD1 und Grundspannung USS1 des zweiten Abschnitts B durch eine elektrostatische Entladung mit zerstörerischer Wirkung, d.h. durch ein ESD-Ereignis (ESD: Electro Static Destruction) im Potential verschoben, so wird die Potentialdifferenz sofort über die Übertragungsleitungen der Verbindung SC auf dem Kristall 1 an die Gates der MOS-Transistoren des anderen Abschnitts übertragen. In wenigen Nanosekunden brechen diese durch und werden zerstört. Mit Blick darauf, dass typische ESD-Ereignisse im KV- und A-Bereich liegen, die Gateoxide die jedoch nur noch typischerweise 6 Volt für 100 ns aushalten, so ist sofort klar, dass eine solche Anordnung untauglich ist.

Fig. 6 skizziert eine Schaltungsanordnung gemäß dem Stand der Technik mit einem Schutz gegen elektrostatische Zerstörung. Die Schaltungsanordnung aus wieder einem ersten und einem zweiten Abschnitt A, B mit jeweils einer anliegenden Versorgungsspannung UDD bzw. UDD1 und einer Grundspannung USS bzw. USS1 weist Koppelelemente auf, welche zwischen die beiden Anschlussleitungen der Versorgungsspannungen UDD, UDD1 des ersten und des zweiten Abschnitts A, B geschaltet sind. Weitere Koppelelemente KP sind zwischen die Anschlussleitungen der Grundspannung USS, USS1 des ersten und des zweiten Abschnitts A, B geschaltet. Die Koppelelemente KP sollen die Potentialdifferenzen des Betriebsspannungssystems UDD-USS des ersten Abschnitts gegenüber dem Betriebsspannungssystem UDD1-USS1 des zweiten Abschnitts B verhindern oder limitieren. Als Koppelelemente werden verschiedenartige Komponenten verwendet, beispielsweise Widerstände, auch der stets vorhandene Substratwiderstand einer integrierten Schaltungsanordnung, Dioden, Biopolartransistoren oder MOS- Transistorvorrichtungen. Bei dieser Anordnung sind die Koppelelemente somit direkt zwischen die beiden Betriebsspannungssysteme der beiden Abschnitte A, B geschaltet. Die Verbindungen SC zur Informationsübertragung sind separat ausgebildet.

Eine solche Schaltungsanordnung ist jedoch nur bedingt einsetzbar, da die Kopplung nur schwach ausgeführt werden kann, weil sonst die Trennung der beiden Abschnitte A, B aufgehoben werden würde und sich Störungen über die Leitungen und Verbindungen der Spannungsversorgung ausbreiten können. Besonders schwierig wird die Kopplung, wenn das Betriebsspannungssystem UDD1-USS1 des zweiten Abschnitts B eine andere Nennspannung als das Betriebsspannungssystem UDD-USS des ersten Abschnitts A hat. Das ständige Fließen von Ausgleichsströmen soll nämlich verhindert werden. Mit Blick auf diese Faktoren werden die Koppelelemente bzw. die Koppler oftmals gewollt oder ungewollt recht uneffektiv, so dass es weiterhin zu Zerstörungen im Fall elektrostatischer Entladungen kommt. Bei beispielsweise einem Koppler mit einem dynamischen Widerstand von 10 Ohm reicht ein ESD-Ausgleichsstrom von 1A und einer Spannungsdifferenz von 10V zwischen den Betriebsspannungssystemen der Abschnitte A, B zur sofortigen Zerstörung an den Gate-Oxiden an den Übergängen des ersten Abschnitts A auf den zweiten Abschnitt B oder umgekehrt.

Typische elektronische Systeme auf Chips, so genannte Systems on Chip (SoC) weisen derzeit drei oder mehr getrennte Teile bzw. Abschnitte mit verschiedenen Nennspannungen auf, so dass die Aufgabe der Entkopplung zur Vermeidung elektrostatischer Entladungen mit zerstörerischer Wirkung zusätzlich erschwert wird. Es wird eine zusätzliche Anzahl von Kopplern benötigt, wobei.die Metallbahnen welche diese Koppler anbinden, einen zusätzlichen Widerstand im Kopplungspfad erzeugen. Parallel sinken von Technologiegeneration zu Technologiegeneration die 100ns-Durchbruchspannungen der dünnen Oxide immer weiter ab. Die Maßnahmen einer Schaltungsanordnung gemäß Fig. 6 sind somit völlig untauglich zur Verhinderung von Schäden durch elektrostatische Entladungen.

Fig. 7 zeigt eine einfache Methode einer Übertragung von Informationen über eine Verbindung SC von einem Inverter IA2 im ersten Abschnitt A zu einem Inverter IB2 im zweiten Abschnitt B. Am Eingang des Inverters IB2 des zweiten Abschnitts B sind an einem Verbindungspunkt OS zwei Dioden D1S, D2S angeschlossen. Die erste der Dioden D1S ist zwischen den Knoten bzw. Verbindungspunkt und die Versorgungsspannung UDD1 des zweiten Abschnitts geschaltet. Die zweite der Dioden D2F ist zwischen die Grundspannung USS1 und den Verbindungspunkt OS geschaltet. Die Dioden D1S, D2S, welche am Betriebsspannungssystem des zweiten Abschnitts B lokal hängen, begrenzen die Spannung am Inverter IB2 des zweiten Abschnitts B. Ein Widerstand RS, welcher zwischen den Inverter IA2 des ersten Abschnitts A und den Verbindungspunkt OS im zweiten Abschnitt B geschaltet ist, begrenzt dabei den Ausgleichsstrom. Die Dioden D1S, D2S können auch durch die Parasiten einer MOS-Struktur ausgebildet werden. Diese Schaltung zusammen mit den Kopplern gemäß Fig. 6 bietet einen Zerstörungsschutz gegen elektrostatische Entladungen. Nachteilig ist jedoch, dass die Betriebsspannungssysteme der beiden Abschnitte A, B nicht mehr voneinander unabhängig sind. Das Betriebsspannungssystem UDD1-USS1 des zweiten Abschnitts B kann z.B. keine niedrigere Nennspannung als das Betriebsspannungssystem UDD-USS des zweiten Abschnitts A haben, weil sonst in der Summe aller Inverter und Widerstände erhebliche Ausgleichsströme fließen würden. Auch ein Abschalten des Betriebsspannungssystems UDD1-USS1 des zweiten Abschnitts B ist kaum sinnvoll möglich. Diese Schaltungsanordnung funktioniert zwar vom Prinzip her, ist jedoch für die Anforderungen vieler Systeme ungeeignet.

Die Aufgabe der Erfindung besteht darin, eine Schaltungsanordnung mit einem alternativen Schutz gegen elektrostatische Zerstörung zwischen zwei Abschnitten mit jeweils eigenem Betriebsspannungssystem vorzuschlagen.

Diese Aufgabe wird durch die Schaltungsanordnung mit den Merkmalen des Patentanspruchs 1 gelöst.

Bevorzugt wird insbesondere eine Schaltungsanordnung mit Schutz gegen elektrostatische Zerstörung mit zumindest zwei Abschnitten aus einem ersten und einem zweiten Abschnitt, wobei jeder der Abschnitte jeweils ein eigenes Betriebsspannungssystem mit einer Grundspannung und einer Versorgungsspannung aufweist, und mit zumindest einer Verbindung zwischen einem Informationsanschlusspunkt des ersten Abschnitts und zwischen einem Informationsanschlusspunkt des zweiten Abschnitts zum Übertragen von Informationen zwischen dem ersten Abschnitt und dem zweiten Abschnitt. Dabei weist die Verbindung eine Transistorschaltung mit zumindest einer Reihenschaltung aus einem ersten Transistor des ersten Abschnitts, einem Widerstand und einem ersten Transistor des zweiten Abschnitts auf, wobei der erste Transistor zwischen die Grundspannung des ersten Abschnitts und den Widerstand und der erste Transistor des zweiten Abschnitts zwischen den Widerstand und die Versorgungsspannung des zweiten Abschnitts geschaltet ist.

Vorteilhafte Ausgestaltungen sind Gegenstand abhängiger Ansprüche.

Bevorzugt wird insbesondere eine Schaltungsanordnung, bei welcher der Übergang zwischen dem ersten Abschnitt und dem zweiten Abschnitt durch den Widerstand oder zwischen dem Widerstand und einem der damit verbundenen Transistoren verläuft.

Bevorzugt wird insbesondere eine Schaltungsanordnung, bei der die Verbindung durch eine Stromspiegelschaltung mit dem Widerstand als zwischengeschaltetem Widerstand ausgebildet wird.

Bevorzugt wird insbesondere eine Schaltungsanordnung, bei welcher eine Diode zwischen die Grundspannung des zweiten Abschnitts und einen Verbindungspunkt zwischen dem ersten Transistor des zweiten Abschnitts und dem Widerstand geschaltet ist.

Bevorzugt wird insbesondere eine Schaltungsanordnung, bei welcher eine Diode zwischen die Versorgungsspannung des ersten Abschnitts und einen Verbindungspunkt zwischen dem ersten Transistor des ersten Abschnitts und dem Widerstand geschaltet ist.

Bevorzugt wird insbesondere eine Schaltungsanordnung, bei welcher der Verbindungspunkt mit dem Steueranschluss des ersten Transistors und eines zweiten Transistors verbunden ist, wobei der zweite Transistor zwischen die Grundspannung (VSS) des ersten Abschnitts und dessen Informationsanschlusspunkt geschaltet ist.

Bevorzugt wird insbesondere eine Schaltungsanordnung, bei welcher der Steueranschluss des ersten Transistors des zweiten Abschnitts den einen Informationsanschlusspunkt ausbildet.

Bevorzugt wird insbesondere eine Schaltungsanordnung, bei der die Verbindung durch eine Pegelschieberschaltung mit zwischengeschaltetem Widerstand ausgebildet ist.

Bevorzugt wird insbesondere eine Schaltungsanordnung, bei der der Informationsanschlusspunkt des ersten Abschnitts invertiert mit dem Steueranschluss des ersten Transistors und nicht invertiert mit dem Steueranschluss eines zweiten Transistors des ersten Abschnitts verbunden ist und der zweite Transistor zwischen die Grundspannung des ersten Abschnitts und einen zweiten Widerstand geschaltet ist und ein zweiter Transistor des zweiten Abschnitts zwischen den zweiten Widerstand und die Versorgungsspannung des zweiten Abschnitts geschaltet ist.

Bevorzugt wird insbesondere eine Schaltungsanordnung, bei der in dem zweiten Abschnitt der Steueranschluss des ersten und des zweiten Transistors jeweils mit einem Verbindungspunkt zwischen dem anderen Transistor und dessen Widerstand verbunden ist.

Bevorzugt wird insbesondere eine Schaltungsanordnung, bei der im zweiten Abschnitt der Verbindungspunkt zwischen den zweiten Transistor und dessen Widerstand mit dem Informationsanschlusspunkt verbunden ist, insbesondere über einen Inverter verbunden ist.

Bevorzugt wird insbesondere eine Schaltungsanordnung, bei der von dem Verbindungspunkt zwischen dem zweiten Transistor und dessen Widerstand im zweiten Abschnitt eine Diode zur Versorgungsspannung geschaltet ist.

Bevorzugt wird insbesondere eine Schaltungsanordnung, bei welcher eine zweite Diode im zweiten Abschnitt von der Grundspannung zu dem Verbindungspunkt zwischen dem zweiten Transistor und dessen Widerstand geschaltet ist.

Bevorzugt wird insbesondere eine Schaltungsanordnung, bei welcher Dioden zum Fernhalten schädlicher Überspannungen von den Transistoren als Klemmdioden, insbesondere als parasitäre Elemente, beim Auslegen der Transistoren ausgebildet sind.

Ein Ausführungsbeispiel wird nachfolgend anhand der Zeichnung näher erläutert. Es zeigen:
- Fig. 1: eine Schaltungsanordnung mit zwei Abschnitten, welche jeweils ein eigenes Betriebspannungssystem aufweisen und welche zur Übertragung von Informationen ver- schiedene Schaltungskomponenten aufweisen, welche einen Schutz gegen elektrostatische Zerstörung bieten;
- Fig. 2: eine Schaltungsanordnung, welche gegenüber der Schaltungsanordnung aus Fig. 1 modifiziert ist;
- Fig. 3: in skizzierter Form Komponenten einer integrierten Schaltungsanordnung zur Umsetzung des Konzepts gemäß Fig. 1;
- Fig. 4: eine alternative Schaltungsanordnung mit Komponenten zum Schutz gegen elektrostatische Zerstörung und zugleich Übertragurigsmöglichkeit von Informationen; und
- Fig.5-7: verschiedene Schaltungsanordnungen gemäß dem Stand der Technik.

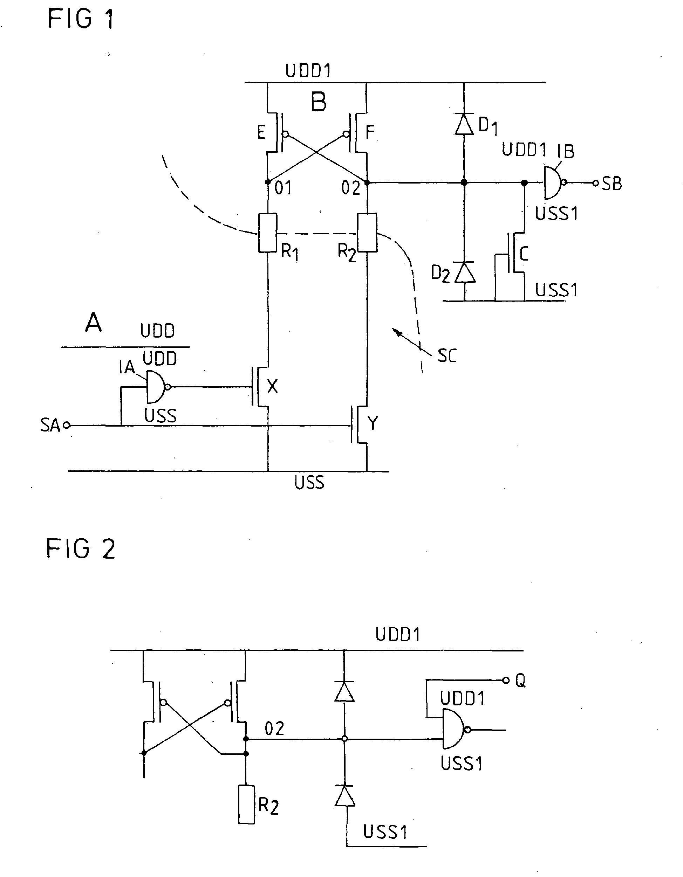

Wie dies aus Fig. 1 ersichtlich ist, ist eine beispielhafte Schaltungsanordnung in verschiedene Abschnitte bzw. Teile untergliedert, wobei beispielhaft ein erster und ein zweiter Abschnitt A, B skizziert sind. Die Schaltungsanordnung kann dabei aus einer Vielzahl von elektronischen Komponenten auf einer oder zwei unter einander verbundenen Platinen bestehen. Bevorzugt wird jedoch eine Schaltungsanordnung in Art einer integrierten Schaltung, bei welcher die beiden Abschnitte A, B auf einem gemeinsamen Kristall 1 angeordnet sind. In diesem Fall sind die einzelnen beschriebenen elektronischen Komponenten in üblicher Art und Weise integrierter Schaltungsanordnungen ausgebildet.

Vom ersten Abschnitt A sind zur Vereinfachung lediglich ein Informationsanschlusspunkt SA zum Anlegen eines Signals, welches zum zweiten Abschnitt B zu Übertragen ist bzw. vom zweiten Abschnitt B empfangen wird, sowie das Betriebsspannungssystem UDD-USS skizziert. Das Betriebsspannungssystem UDD-USS besteht aus einer Masse bzw. allgemein Grundspannung USS an einer entsprechenden Masseleitung sowie aus einer Versorgungsspannung UDD an einer entsprechenden Versorgungsspannungsleitung.

Der zweite Abschnitt B weist einen entsprechenden Informationsanschlusspunkt SB zum Übertragen von Informationen bzw. Signalen an den ersten Abschnitt A bzw. von diesem auf. Außerdem weist der zweite Abschnitt B ein eigenes Betriebsspannungssystem UDD1-USS1 auf, welches entsprechend eine Masse oder Grundspannung USS1 an einer Masseleitung und eine Versorgungsspannung UDD1 an einer Versorgungsleitung bereitstellt. Die beiden Betriebsspannungssysteme des ersten und des zweiten Abschnitts A, B können je nach spezieller Ausgestaltung der Schaltungsanordnung prinzipiell auch mit Blick auf die Grundspannung USS, USS1 und/oder die Versorgungsspannung UDD, UDD1 miteinander verbunden sein. Besonders bevorzugt werden jedoch Ausgestaltungen mit eigenständigen Betriebsspannungssystemen UDD-USS, UDD1-USS1.

Als Zerstörungsschutz zum Verhindern von Zerstörungen im Fall elektrostatischer Entladungen in einem oder beiden der Abschnitte A, B über eine Verbindung SC zwischen den Informationsanschlusspunkten SA, SB der beiden Abschnitte A, B ist eine Vielzahl von einzelnen Komponenten zwischen den beiden Abschnitten A, B geschaltet. Durch diese Anordnung wird ein ESD-Schutz ohne eine Einschränkung von Funktionalität oder Applikationen der Schaltungsanordnung ermöglicht. Zur Verbindung der beiden Abschnitte A, B wird gemäß der ersten bevorzugten Ausführungsform eine Anordnung eingesetzt, wie sie für sich genommen im Wesentlichen als Pegelschieberschaltung (level shifter) bekannt ist. Im Vergleich zu einer herkömmlichen Pegelschieberschaltung sind jedoch zusätzliche ersten Widerstände R1, R2 und gegebenenfalls Dioden D1, D2 bzw. parasitäre Dioden von MOS-Transistoren zum Begrenzen von Spannungen und Strömen eingesetzt. Die Informationsübertragung erfolgt somit über eine modifizierte Pegelschieberschaltung vor allem in Form von Strömen anstelle einer Übertragung in Form von Spannungen. Die Nennspannungen der Abschnitte A, B sind dabei nicht direkt aneinander gekoppelt, so dass im Rahmen der technologischen Parameter eingesetzte Transistoren unabhängig voneinander jegliche Spannungen in den Abschnitten a, B eingesetzt werden können. Insbesondere wird sogar das Abschalten eines oder beider Abschnitte A, B unabhängig voneinander ermöglicht.

Der Informationsanschlusspunkt SA des ersten Abschnitts A ist über einen Inverter IA, welcher dem Betriebsspannungssystem UDD-USS des ersten Abschnitts A zugeordnet ist, mit dem Steueranschluss eines ersten Transistors X des ersten Abschnitts A verbunden. Der erste Transistor X des ersten Abschnitts A ist zwischen die Grundspannung USS des ersten Abschnitts A und einen ersten Widerstand R1 geschaltet. Der zweite Anschluss des Widerstands R1 ist über einen Knoten bzw. einen Verbindungspunkt 01 mit einem ersten Transistor E des zweiten Abschnitts B verbunden. Der erste Transistor E des zweiten Abschnitts B ist zwischen den ersten Widerstand R1 bzw. den ersten Verbindungspunktpunkt 01 und die Versorgungsspannung UDD1 des zweiten Abschnitts B geschaltet. Der Steueranschluss des ersten Transistors E des zweiten Abschnitts B ist über einen Knoten bzw. zweiten Verbindungspunkt 02 und einen Inverter IB des zweiten Abschnitts B mit dem Informationsanschlusspunkt SB des zweiten Abschnitts B verbunden. Der Inverter IB des zweiten Abschnitts B ist dessen Betriebsspannungssystem UDD1-USS1 zugeordnet. Zwischen den zweiten Verbindungspunkt 02 und die Versorgungsspannung UDD1 des zweiten Abschnitts B ist eine erste Diode D1 geschaltet. Zwischen die Grundspannung USS1 und den zweiten Verbindungspunkt 02 des zweiten Abschnitts B sind ein dritten Transistor C und eine zweite Diode D2 geschaltet. Außerdem ist der Steueranschluss des dritten Transistors C mit der Grundspannung USS1 verbunden.

Außerdem ist der Informationsanschlusspunkt SA des ersten Abschnitts A mit einem Steueranschluss eines zweiten Transistors Y des ersten Abschnitts A verbunden. Der zweite Transistor Y des ersten Abschnitts A ist zwischen die Grundspannung USS des ersten Abschnitts A und einen zweiten Widerstand R2 geschaltet. Der zweite Anschluss des zweiten Widerstands R2 ist mit dem zweiten Verbindungspunkt 02 des zweiten Abschnitts B verbunden. Außerdem ist ein zweiter Transistor F des zweiten Abschnitts B zwischen den zweiten Verbindungspunkt 02 und die Versorgungsspannung UDD1 des zweiten Abschnitts B geschaltet. Der Steueranschluss des zweiten Transistors F ist mit dem ersten Verbindungspunkt O1 des zweiten Abschnitts B verbunden.

Der erste und der zweite Transistor X, Y, E, F des ersten und des zweiten Abschnitts A, B bilden somit vom Grundprinzip her eine Pegelschieberschaltung mit zwischengeschalteten Widerständen R1, R2 und gegebenenfalls zwei Klemmdioden D1, D2 aus. Die Klemmdioden in Form der ersten und der zweiten Diode D1, D2 sind bei geeigneter Auslegung der drei Transistoren E, F, C des zweiten Abschnitts B als Parasiten vorhanden. Da die weiteren Komponenten des ersten und des zweiten Abschnitts A, B mit Blick auf einen ESD-Schutz keine besondere Funktionalität oder Ausgestaltung aufweisen, reicht daher die Skizzierung der wenigen dargestellten Komponenten.

Im wesentlichen bleibt die Grundfunktion des Pegelschiebers, welcher in der erweiterten Form die Verbindung SC zwischen den Informationsanschlusspunkten SA, SB ausbildet, erhalten. Abhängig vom Eingangssignal am Informationsanschlusspunkt SA des ersten Abschnitts A ziehen die beiden Transistoren X, Y des ersten Abschnitts A an dem zweiten bzw. ersten Transistor F, E des zweiten Abschnitts B. Dadurch sinkt das Potential an den Verbindungspunkten O1, O2. Dadurch schaltet derjenige Transistor E, F ein, welcher auf dem dem ziehenden Transistor Y, X gegenüberliegenden Knoten 02, 01 liegt. Dies zieht den gegenüberliegenden der Knoten 02, O1 herauf und schaltet schließlich den Transistor E bzw. F im zweiten Abschnitt B am durch den Transistor Y bzw. X des ersten Abschnitts A gezogenen Verbindungspunkt 02 bzw. 01 ab. Ein neuer stabiler Zustand ist erreicht. Es findet eine kreuzweise Rückkopplung der beiden Transistoren E, F des zweiten Abschnitts B statt.

Hervorzuheben ist, dass die Grenze zwischen dem ersten und dem zweiten Abschnitt A, B nun quer durch die Schaltungsanordnung, insbesondere quer durch die beiden Widerstände R1, R2 oder benachbart zu diesen verläuft. Beliebige Elemente im ersten Abschnitt A können nun in Bezug auf beliebige Elemente im zweiten Abschnitt B Ausgleichsbewegungen im Sinne einer Gleichtaktstörung, beispielsweise durch elektrostatische Entladungen, durchführen. Schädliche Überspannungen werden durch die beiden Dioden D1, D2 vom Inverter IB im zweiten Abschnitt B ferngehalten, indem sie auf dessen lokale Spannungsversorgung, d.h. auf dessen Betriebsspannungssystem UDD1-USS1 klemmen. Durch geeignete Auslegung der Transistoren E, F, C des zweiten Abschnitts B sind diese Dioden D1, D2 vorzugsweise bereits als parasitäre Elemente vorhanden bzw. umsetzbar.

Die beiden Widerstände R1, R2 werden bei derartigen Ausgleichsvorgängen Ströme vom ersten Abschnitt A zum zweiten Abschnitt B begrenzen, so dass keine Zerstörungen durch Stromwärme auftreten. Somit ist insbesondere besonders bevorzugt in Kombination mit für sich bekannten Kopplern eine Zerstörung an den Gates an dem Inverter IB im zweiten Abschnitt B verhinderbar oder zumindest weiter reduzierbar. Insbesondere können die beiden Systeme bzw. Abschnitte A, B prinzipiell beliebige Spannungen aufweisen, solange die Transistoren technologisch dafür ausgelegt sind und die Schaltungsanordnung zu keinen oder nicht störenden Ausgleichsströmen führt. Insbesondere ist möglich, dass die Spannung im ersten Abschnitt A betriebsmäßig niedriger als die Spannung im zweiten Abschnitt B oder umgekehrt ist.

Es kann sogar ein Abschnitt A, B vollständig abgeschaltet werden, ohne dass negative Begleiterscheinungen für insbesondere den zweiten Abschnitt B auftreten. Wenn der erste Abschnitt A abgeschaltet wird, so können jedoch durch Gleichrichtereffekte, Leckströme usw. unsinnige Signale vom ersten Abschnitt A bis zum zweiten Knoten 02 im zweiten Abschnitt B vordringen, wie dies in Fig.2 skizziert ist. Dadurch werden zwar keine Schäden auftreten, der zweite Abschnitt B oder Komponenten in diesem können jedoch verwirrt bzw. gestört werden. Zur Vermeidung wird daher bevorzugt ein logisches Klemmelement der Schaltungsanordnung hinzugefügt, welches z.B. als eine NAND-Schaltung mittels eines Eingangs Q jegliche Ausbreitung solcher gestörter Signale unterbindet, insbesondere sicher unterbindet.

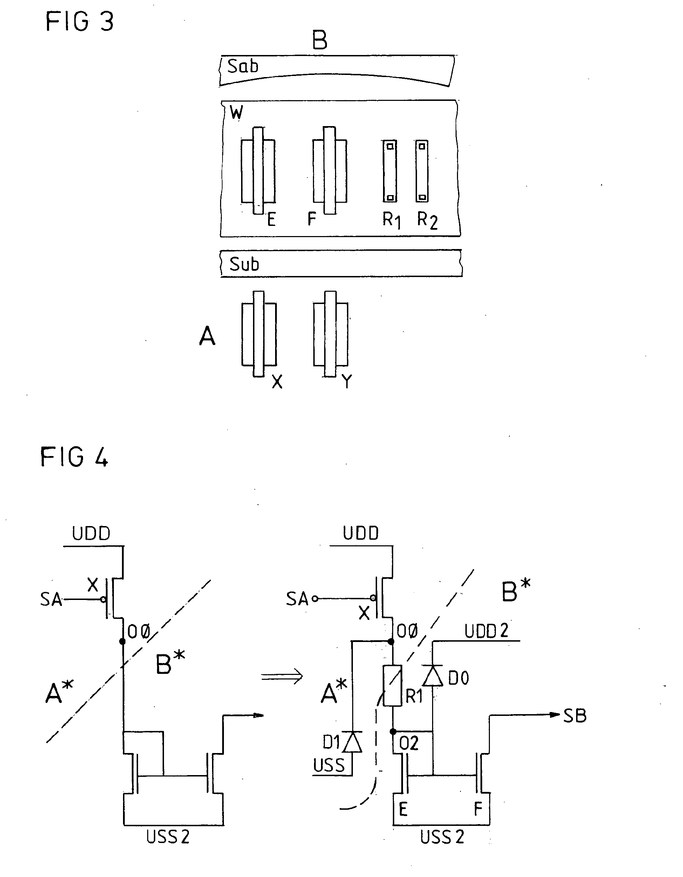

Fig. 3 zeigt in Draufsicht die schematische Verteilung von einzelnen elektronischen Komponenten auf einem Kristall 1 einer integrierten Schaltungsanordnung mit zwei Abschnitten A, B. Die beiden Abschnitte A, B sollen wie bei der Anordnung aus Fig.1 geschaltet sein. Die dargestellte Anordnung zeigt ein Beispiel für ein Layout, welches sehr ökonomisch und technisch sinnvoll ausführbar ist. Angeordnet wird ein Abschnitt A mit zwei Transistoren X, Y, welche den beiden Transistoren gemäß Fig.1 beispielhaft entsprechen. Versetzt dazu findet sich der zweite Abschnitt B mit seinen entsprechenden Komponenten.

Vom ersten Abschnitt A aus in Richtung des zweiten Abschnitts B erstreckt sich quer zum ersten Abschnitt A ein Abschnitt eines optionalen Substratrings Sub, gefolgt von einer Wanne W und wiederum einem Abschnitt eines weiteren Substratrings oder des Substratrings Sub. In der Wanne W sind die beiden Widerstände R1, R2 sowie der erste und der zweite Transistor E, F in PMOST-Bauweise (PMOST: P-Kanal-MOS-Feldeffekttransistor) angeordnet. Auf diese Art und Weise kann die Grenze zwischen dem ersten und dem zweiten Abschnitt B sehr praktisch ausgeführt werden.

Die ESD-Schutzfunktion, welche in Verbindung mit Fig. 1 beschrieben ist, kann dabei vorteilhaft mit einer Trennung des Substrates bzw. Kristalls 1 durch die Wanne W mit störungsableitenden Substratringen Sub verbunden werden, so dass der Anteil von Störungen, die durch das Substrat vom ersten Abschnitt A zum zweiten Abschnitt B bzw. in umgekehrter Richtung gelangen, minimiert wird. Die Substratringe Sub sind dabei direkt mit dem entsprechenden Grundpotential USS der jeweiligen Seite bzw. des jeweiligen Abschnitts A, B zu verbinden. Die Substratringe Sub bzw. entsprechende Bereiche verhindern dadurch, dass Störungen direkt zu den Versorgungspunkten bzw. Informationsanschlusspunkten SA, SB geleitet werden. Die dadurch entstehenden Ausgleichsströme sollen nicht in empfindliche Netzwerke der Schaltungen in den Abschnitten A, B eingeschleppt werden, was durch ein solches Layout-Design erreicht wird. Durch Anreihen einer Vielzahl solcher Layout-Zellen kann eine durchgehende Barriere zwischen den Abschnitten A und B errichtet werden, über welche aber immer noch auf sichere Art und Weise Signale hin- und her gehen. Insbesondere kann eine Vielzahl weiterer zusätzlicher Abschnitte auf diese Art und Weise in beliebigen Richtungen des Layouts aneinander gereiht werden.

Während anhand der Fig. 1 und 2 eine beispielhafte Schaltungsanordnung auf Basis einer Pegelschieberschaltung dargestellt ist, ist gemäß Fig. 4 auch eine Umsetzung der Grundfunktion des vorstehend beschriebnen Prinzips auf lineare Schaltungen zu deren Schutz vor elektrostatischer Zerstörung umsetzbar. Anschaulich beschrieben wird dazu ein Aufschneiden der beiden Zweige des Pegelschiebers vorgenommen, so dass eine Restschaltung zurückbleibt, welche an die für sich bekannte Strömspiegelschaltung erinnert.

Fig. 4 zeigt auf der linken Seite einen konventionellen Stromspiegel, welcher Signale SA von einem ersten Abschnitt A* zu einem zweiten Abschnitt B* überträgt. Ein erster Transistor X des ersten Abschnitts A* wird dabei zwischen dessen Versorgungsspannung UDD und einen ersten Verbindungspunkt 00 bzw. Übergangspunkt zum zweiten Abschnitt B* geschaltet. Im zweiten Abschnitt B* befindet sich ein Stromspiegel, der mit der Versorgungsgrundspannung USS2 des zweiten Abschnitts B* als Gegenpol verbunden ist. Störungen werden somit vom einen in den anderen Abschnitt A*, B* übertragen.

Auf der rechten Seite von Fig. 4 ist eine erweiterte Stromspiegelschaltung dargestellt, welche einen ESD-Schutz bietet. Gegenüber der herkömmlichen Schaltung werden wiederum ein Widerstand R1 und zwei Dioden D0, D2 als Klemmdioden im Sinne der Schaltungsanordnung gemäß Fig. 1 und 2 eingefügt.

Der erste Transistor X, an dem das Signal SA zu dessen Steuerung angelegt wird, ist zwischen die Versorgungsspannung UDD des ersten Abschnitts A* und den ersten Verbindungspunkt 00 des ersten Abschnitts A* geschaltet. Außerdem ist zwischen die Basis- bzw. Grundspannung USS und den ersten Verbindungspunkt 00 eine erste Diode D1 geschaltet. Zwischen den ersten Verbindungspunkt 00 des ersten Abschnitts A* und einen zweiten Verbindungspunkt 02 des zweiten Abschnitts B* ist ein Widerstand R1 geschaltet. Durch diesen Widerstand R1 oder benachbart dazu verläuft die Grenze zwischen dem ersten und dem zweiten Abschnitt A*, B*.

Von dem zweiten Verbindungspunkt 02 und einer Basis- bzw. Grundspannung USS2 des zweiten Abschnitts B* ist ein Stromspiegel aus zwei Transistoren E, F geschaltet. Der erste dieser Transistoren E ist dabei direkt zwischen den zweiten Verbindungspunkt 02 und die Grundspannung USS2 geschaltet. Der zweite Transistor F ist zwischen die Grundspannung VSS2 und einen Informationsanschlusspunkt SB des zweiten Abschnitts B* geschaltet. Außerdem wird über eine Verbindung zwischen dem zweiten Verbindungspunkt 02 und den beiden Steueranschlüssen der beiden Transistoren E, F ein Steuersignal entsprechend an den beiden Transistoren E, F angelegt. Zusätzlich ist zwischen den zweiten Verbindungspunkt 02 und eine Versorgungsspannung UDD2 des zweiten Abschnitts B* eine zweite Diode D0 geschaltet.

Die beiden beispielhaften Schaltungsanordnungen lassen sich prinzipiell in jeder CMOS-Schaltung, welche zwei oder mehr verschiedene, nominell gleiche oder ungleiche Betriebsspannungssysteme hat, anwenden. Besondere Vorteile bringen sie bei großen Unterschieden der verschiedenen Betriebsspannungen. Dies ist beispielsweise bei fortgeschrittenen CMOS-Prozessen der 0,18µm- oder der 0,13µm-Klasse der Fall, wo die Kernspannung nur 1,8V oder 1,2V beträgt, die Eingangs-AusgangsSpannung aber 3,3V beträgt.

Die Anwendung ist dabei nicht auf digitale Schaltungen begrenzt. Auch analoge Schaltungen benötigen derartige Pegelumsetzer für digitale Steuersignale etc., so dass eine Übertragung entsprechend möglich ist.

Außerdem ist eine Anwendung in diskreten Systemen umsetzbar und ist nicht auf eine integrierte Schaltungsanordnung begrenzt. Ferner sind die Polaritäten der Spannungen und der Transistortypen in üblicher Art und Weise austauschbar. Prinzipiell kann die Schaltung auch mit Biopolartransistoren aufgebaut werden.

Ferner kann die Schaltung in sehr großen Systemen eingesetzt werden, in denen zwar nur ein übergeordnetes System für die Spannung existiert, dieses aber so groß ist, dass zwei entfernte Punkte des großen Systems wie separierte Netze behandelt werden müssen. Im Fall eines Chips kann dies schon bei wenigen Millimetern Leitungslänge der Fall sein.

Der Pegelschieberkern kann außerdem ohne weiteres mit verschiedenen für sich bekannten Beschleunigungsmethoden kombiniert werden, wobei das Prinzip der beschriebenen Schaltungsanordnungen trotzdem vorteilhaft umsetzbar ist. Die elektronischen Komponenten, insbesondere Widerstände können von beliebiger Bauart sein, insbesondere diffundierte Widerstände mit hoher Abbruchspannung oder isolierte Widerstände, wie beispielsweise Metallfilm- oder Polysilizium-Widerstände.

## Patentansprüche

1. Schaltungsanordnung mit Schutz gegen elektrostatische Zerstörung mit
- zumindest zwei Abschnitten (A, B) aus einem ersten und einem zweiten Abschnitt (A, B), wobei jeder der Abschnitte (A, B) jeweils ein eigenes Betriebsspannungssystem mit einer Grundspannung (USS bzw. USS1) und einer Versorgungsspannung (UDD' bzw. UDD1) aufweist, und
- zumindest einer Verbindung (SC) zwischen einem Informationsanschlusspunkt (SA) des ersten Abschnitts (A) und zwischen einem Informationsanschlusspunkt (SB) des zweiten Abschnitts (B) zum Übertragen von Informationen zwischen dem ersten Abschnitt (A) und dem zweiten Abschnitt (B),
**dadurch gekennzeichnet , dass**
- die Verbindung (SC) eine Transistorschaltung mit zumindest einem ersten Transistor (X) des ersten Abschnitts (A), einem Widerstand (R1) und einem ersten Transistor (E) des zweiten Abschnitts (B) aufweist, wobei der erste Transistor (X) zwischen die Grundspannung (USS) des ersten Abschnitts (A) und den Widerstand (R1) und der erste Transistor (E) des zweiten Abschnitts (B) zwischen den Widerstand (R1) und die Versorgungsspannung (UDD1) des zweiten Abschnitts (B) geschaltet ist.

2. Schaltungsanordnung nach Anspruch 1, bei welcher der Übergang zwischen dem ersten Abschnitt (A) und dem zweiten Abschnitt (B) durch den Widerstand (R1) oder zwischen dem Widerstand (R1) und einem der damit verbundenen Transistoren (X, E) verläuft.

3. Schaltungsanordnung nach Anspruch 1 oder 2, bei der die Verbindung (SC) durch eine Stromspiegelschaltung mit dem Widerstand (R1) als zwischengeschaltetem Widerstand ausgebildet wird.

4. Schaltungsanordnung nach einem vorstehenden Anspruch, bei welcher eine Diode (D2) zwischen die Grundspannung (USS1) des zweiten Abschnitts (B) und einen Verbindungspunkt (O1) zwischen dem ersten Transistor (E) des zweiten Abschnitts (B) und dem Widerstand (R1) geschaltet ist.

5. Schaltungsanordnung nach einem vorstehenden Anspruch, welcher eine Diode (D1) zwischen die Versorgungsspannung (UDD) des ersten Abschnitts (A) und einen Verbindungspunkt (O0) zwischen dem ersten Transistor (X) des ersten Abschnitts (A) und dem Widerstand (R1) geschaltet ist.

6. Schaltungsanordnung nach einem der Ansprüche 3 - 5, bei welcher der Verbindungspunkt (O0) mit dem Steueranschluss des ersten Transistors und eines zweiten Transistors (X*) verbunden ist, wobei der zweite Transistor (X*) zwischen die Grundspannung (USS) des ersten Abschnitts (A) und dessen Informationsanschlusspunkt (SA) geschaltet ist.

7. Schaltungsanordnung nach einem der Ansprüche 3 - 6, bei welcher der Steueranschluss des ersten Transistors des zweiten Abschnitts (B) den einen Informationsanschlusspunkt (SB) ausbildet.

8. Schaltungsanordnung nach einem vorstehenden Anspruch, bei der die Verbindung (SC) durch eine Pegelschieberschaltung mit zwischengeschaltetem Widerstand (R1, R2) ausgebildet ist.

9. Schaltungsanordnung nach Anspruch 1, 2 oder 8, bei der
- der Informationsanschlusspunkt (SA) des ersten Abschnitts (A) invertiert mit dem Steueranschluss des ersten Transistors (X) und nicht invertiert mit dem Steueranschluss eines zweiten Transistors (Y) des ersten Abschnitts (A) verbunden ist und
- der zweite Transistor (Y) zwischen die Grundspannung (USS) des ersten Abschnitts (A) und einen zweiten Widerstand (R2) geschaltet ist und
- ein zweiter Transistor (F) des zweiten Abschnitts (B) zwischen den zweiten Widerstand (R2) und die Versorgungsspannung (UDD1) des zweiten Abschnitts (B) geschaltet ist.

10. Schaltungsanordnung nach Anspruch 9, bei der in dem zweiten Abschnitt (B) der Steueranschluss des ersten und des zweiten Transistors (E, F) jeweils mit einem Verbindungspunkt (02, 01) zwischen dem anderen Transistor (F, E) und dessen Widerstand (R2, R1) verbunden ist.

11. Schaltungsanordnung nach Anspruch 10, bei der im zweiten Abschnitt (B) der Verbindungspunkt (O2) zwischen den zweiten Transistor (F) und dessen Widerstand (R2) mit dem Informationsanschlusspunkt (SB) verbunden ist, insbesondere über einen Inverter (IB) verbunden ist.

12. Schaltungsanordnung nach einem der Ansprüche 9 -11, bei der von dem Verbindungspunkt (O2) zwischen dem zweiten Transistor (F) und dessen Widerstand (R2) im zweiten Abschnitt (B) eine Diode (D1) zur Versorgungsspannung (UDD1) geschaltet ist.

13. Schaltungsanordnung nach einem der Ansprüche 9 - 12, bei welcher eine zweite Diode (D2) im zweiten Abschnitt (B) von der Grundspannung (USS1) zu dem Verbindungspunkt (O2) zwischen dem zweiten Transistor (F) und dessen Widerstand (R2) geschaltet ist.

14. Schaltungsanordnung nach einem vorstehenden Anspruch, bei welcher Dioden (D1, D2, D0) zum Fernhalten schädlicher Überspannungen von den Transistoren als Klemmdioden, insbesondere als parasitäre Elemente, beim Auslegen der Transistoren ausgebildet sind.
